# EUROPEAN PATENT SPECIFICATION

(11) **EP 2 792 485 B1**
(45) Date of publication and mention of the grant of the patent: **08.03.2017**
(21) Application number: 12857829.1
(22) Date of filing: 26.11.2012
(51) Int. Cl.: H01L 31/042, B32B 27/30, C09D 7/12, C09D 175/04, C08G 18/62, C08G 18/75, C08G 18/76, C08G 18/79, C08J 7/04, C08L 75/04, C09D 127/12

(54) **SOLAR CELL BACK SHEET, SOLAR CELL MODULE, AND SOLAR CELL PANEL**
RÜCKSEITIGE FOLIE EINER SOLARZELLE, SOLARZELLENMODUL, UND SOLARZELLENPANEEL
PLAQUE ARRIÈRE DE CELLULES SOLAIRES, MODULE DE CELLULES SOLAIRES ET PANNEAU DE CELLULES SOLAIRES

(30) Priority: 15.12.2011 JP 2011274918
(43) Date of publication of application: 22.10.2014
(73) Proprietor: Daikin Industries, Ltd., Osaka-shi, Osaka 530-8323 (JP)
(72) Inventor: NAKAGAWA Hideto, Osaka-shi, Osaka 530-8323 (JP); GOBOU Kenji, Osaka-shi, Osaka 530-8323 (JP); OZAKI Hidenori, Osaka-shi, Osaka 530-8323 (JP); ASANO Kazuya, Osaka-shi, Osaka 530-8323 (JP); SAGISAKA Shigehito, Osaka-shi, Osaka 530-8323 (JP)
(74) Representative: Goddar, Heinz J.
(86) International application number: PCT/JP2012/080498
(87) International publication number: WO 2013/088943

(56) References cited:
- WO-A1-2011/084438
- WO-A1-2011/087046
- JP-A- 2011 162 598
- JP-A- 2011 162 598
- JP-A- 2011 210 835
- JP-A- 2011 210 835

## Description

### TECHNICAL FIELD

The present invention relates to a solar cell backsheet, a solar cell module, and a solar cell panel.

### BACKGROUND ART

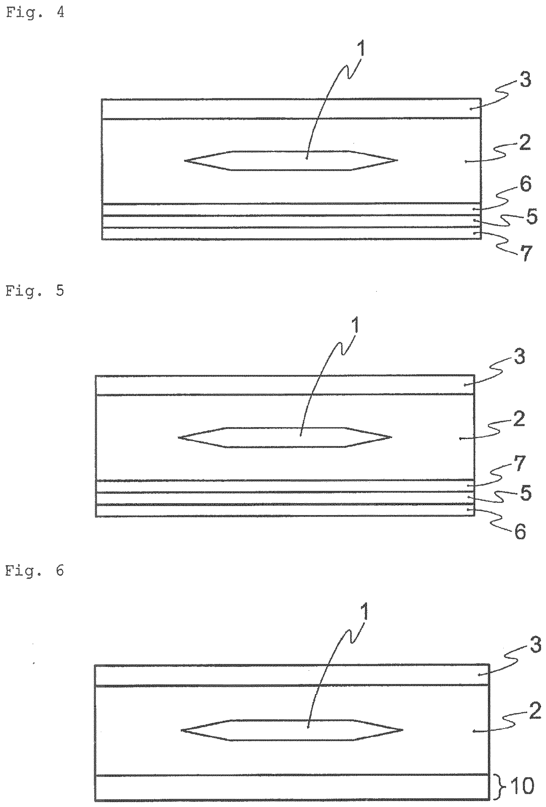

Solar cell modules typically have a structure in which, as shown in Fig. 6, a solar cell 1 is sealed by a sealant layer 2 and this is laminated sandwiched between a backsheet 10 and a surface layer 3 of, for example, glass or a transparent resin. An ethylene/vinyl acetate copolymer (EVA) is generally used as the sealant here.

The backsheet 10 in a solar cell module functions to increase the mechanical strength of the module and also functions to prevent moisture (water vapor) from entering the sealant layer 2.

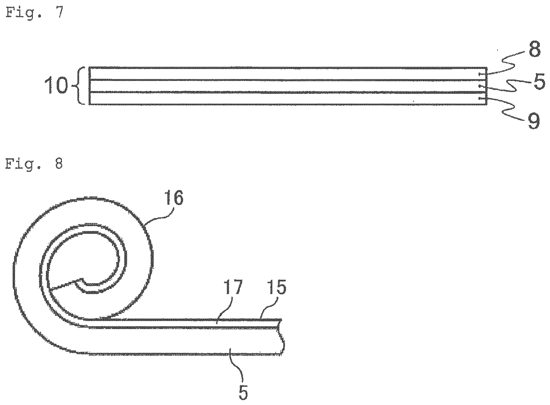

The backsheet 10 typically has a structure in which, as shown in Fig. 7, a resin sheet 8 is bonded on one side of a substrate sheet 5 that provides electrical insulation and a water vapor barrier effect, while a resin sheet 9 is also bonded on the other side of the substrate sheet.

A resin, e.g., a polyester, that exhibits an excellent electrical insulation and an excellent water impermeability is typically used as the material of the substrate sheet 5, and a film thickness of 50 to 250 µm is typically used here.

When an enhanced moistureproofness is required, an Si-deposited polyester, which has an enhanced water impermeability, or a metal, e.g., aluminum or stainless steel, is used, and a film thickness of 10 to 20 µm is typically used here.

Properties such as, inter alia, weathering resistance, electrical insulation, and flame retardancy are required of the resin sheet 8 or 9, and polyvinyl fluoride (PVF) sheet is in use therefor. In addition, for example, a polyethylene sheet may also be used as the resin sheet used on the sealant layer 2 side.

The formation, in place of the resin sheet, of a cured coating film using a resin coating material has been proposed with a view to weight reduction. For example, taking as an object the introduction of a solar cell backsheet that exhibits an excellent adherence between the water-impermeable sheet and a layer obtained from a resin coating material, Patent Literature 1 discloses a solar cell module backsheet in which a cured coating film is formed from a curable functional group-containing fluorinated polymer coating material on at least one side of the water-impermeable sheet.

In Patent Literature 2, a solar cell module backsheet has also been disclosed in which a cured coating film layer is formed, on one side or both sides of a substrate sheet, from a coating material that contains a fluorinated polymer (A) that has a repeat unit based on (a) a fluoroolefin, a repeat unit based on (b) a crosslinking group-containing monomer, and a repeat unit based on (c) an alkyl group-containing monomer in which a polymerizable unsaturated group is connected by an ether bond or ester bond to a C₂₋₂₀ straight-chain or branched alkyl group that does not contain the quaternary carbon atom.

A solar cell backsheet may be wound into a roll configuration during its production and may be stored wound into a roll form. However, conventional backsheets, when wound into a roll as shown in Fig. 8, have undergone press-bonding (blocking) between a first side 15 and a second side 16, and there has been room for improvement with regard to the blocking resistance.

Patent Literature 3 discloses a coating material composition that contains an acrylic resin and a fluorine-containing copolymer constituted of a tetrafluoroethylene structural unit and a hydroxyl group-containing vinyl monomer structural unit. However, neither the use of this coating material composition in a solar cell backsheet nor the resistance to blocking is in any way described in Patent Literature 3.

JP 2011-210835 A discloses back sheets for solar cell modules with cross-linked coatings of modified fluorinated resin and acrylic resin.

### CITATION LIST

### - Patent Literature

- Patent Literature 1:: WO 2007/010706
- Patent Literature 2:: WO 2009/157449
- Patent Literature 3:: JP-A 2004-204205

### SUMMARY OF INVENTION

### - Technical Problem

In view of the circumstances described above, an object of the present invention is to provide a solar cell backsheet that exhibits an excellent blocking resistance.

### - Solution to Problem

The present inventors carried out intensive investigations into solar cell backsheets that would have an improved blocking resistance with respect to contacting surfaces and discovered that an excellent blocking resistance with respect to contacting surfaces is exhibited by a backsheet that has on a surface a cured coating film obtained by the crosslinking of a coating material that contains a specific fluorine-containing polymer and an acrylic polymer.

Thus, the present invention is a solar cell module comprising a substrate sheet and a cured coating film formed from a coating material that contains a curable functional group-containing fluorinated polymer and an acrylic polymer, Wherein the acrylic polymer is at least one polymer selected from the group consisting of (i) polymers that contain an alkyl (meth) acrylate-based polymerization unit and that do not have a curable functional group in side chain position and/or main chain terminal position (acrylic polymer (i)) and (ii) copolymers that contain an alkyl (meth)acrylate-based polymerization unit and that have a curable functional group in side chain position and/or main chain terminal position (acrylic polymer (ii)), wherein the acrylic polymer (ii) contains an alkyl (meth) acrylate-based polymerization unit and a polymerization unit based on a monomer that is copolymerizable with the alkyl (meth) acrylate, wherein the copolymerizable monomer contains a curable functional group, and the content of the polymerization unit based on a curable functional group-containing monomer that is copolymerizable with alkyl (meth) acrylate is not more than 50 weight% in the acrylic polymer with reference to the total polymerization units.

Preferred embodiments are disclosed in the sub-claims.

The present invention is also a solar cell module that is provided with the aforementioned backsheet and a sealant layer that seals a solar cell in its interior.

The present invention is also a solar cell panel that is provided with the aforementioned backsheet.

### - Advantageous Effects of Invention

The solar cell backsheet of the present invention exhibits an excellent blocking resistance.

### (BRIEF DESCRIPTION OF DRAWINGS)

Fig. 1 is a cross-sectional schematic diagram that shows a first embodiment of the solar cell module of the present invention;
Fig. 2 is a cross-sectional schematic diagram that shows a second embodiment of the solar cell module of the present invention;
Fig. 3 is a cross-sectional schematic diagram that shows a third embodiment of the solar cell module of the present invention;
Fig. 4 is a cross-sectional schematic diagram that shows a fourth embodiment of the solar cell module of the present invention;
Fig. 5 is a cross-sectional schematic diagram that shows a fifth embodiment of the solar cell module of the present invention;
Fig. 6 is a cross-sectional schematic diagram of a conventional solar cell module;
Fig. 7 is a schematic cross-sectional diagram of a weathering-resistant backsheet of a conventional solar cell module; and
Fig. 8 is a descriptive diagram for describing the press-bonding between a first side and a second side of a backsheet, which is produced when a backsheet is wound into a roll.

### DESCRIPTION OF EMBODIMENTS

The solar cell backsheet of the present invention, because it contains a substrate sheet and a cured coating film from a coating material that contains a curable functional group-containing fluorinated polymer and an acrylic polymer, does not undergo blocking even when the backsheet is wound into a roll configuration during its production sequence or during its storage.

In addition, because this cured coating film is obtained by curing a coating material that contains a curable functional group-containing fluorinated polymer and an acrylic polymer, an excellent adherence is obtained between it and the sealant in the solar cell (for example, an ethyl vinyl alcohol resin). An excellent weathering resistance, electrical insulation, and flame retardancy are also obtained due to the presence of this cured coating film. The use of the cured coating film also provides a weight reduction superior to that for the bonding to the substrate sheet of a sheet composed, e.g., of a plastic.

Here, blocking refers to a phenomenon in which, when a coated product is wound up or stacked, unwanted adhesion occurs between surfaces in contact with each other (an uncoated surface in contact with a coated surface, a coated surface in contact with a different coated surface, and so forth), which can interfere with separation and can cause the coating film on a coated surface to adhere to a surface in contact with the coated surface.

The coating material for forming the cured coating film contains a curable functional group-containing fluorinated polymer and an acrylic polymer.

The curable functional group-containing fluorinated polymer can be exemplified by a polymer provided by the introduction of a curable functional group into a fluorinated polymer. This curable functional group-containing fluorinated polymer encompasses resinous polymers that have a distinct melting point, elastomeric polymers that exhibit rubbery elasticity, and thermoplastic elastomeric polymers intermediate between these two.

The functional group that imparts curability to the fluorinated polymer is selected as appropriate in conformity with the ease of production of the polymer and the curing system and can be exemplified by the hydroxyl group (but excluding the hydroxyl group present in the carboxyl group; this also applies hereafter), the carboxyl group, the group represented by -COOCO-, the cyano group, the amino group, the glycidyl group, the silyl group, and the silanate group. Among the preceding, at least one group selected from the group consisting of the hydroxyl group, the carboxyl group, the group represented by -COOCO-, the amino group, the cyano group, and the silyl group is preferred for the excellent curing reactivity thereby provided, while at least one group selected from the group consisting of the hydroxyl group, the carboxyl group, the amino group, and the silyl group is more preferred and at least one group selected from the group consisting of the hydroxyl group and the carboxyl group is even more preferred. These curable functional groups are generally introduced into the fluorinated polymer by the copolymerization of a curable functional group-containing monomer.

The curable functional group-containing monomer can be exemplified by hydroxyl group-containing monomers, carboxyl group-containing monomers, amino group-containing monomers, and silicone-based vinyl monomers, and a single one of these may be used or two or more may be used.

The curable functional group-containing fluorinated polymer under consideration preferably contains a polymerization unit based on a fluorine-containing monomer and a polymerization unit based on at least one curable functional group-containing monomer selected from the group consisting of hydroxyl group-containing monomers, carboxyl group-containing monomers, amino group-containing monomers, and silicone-based vinyl monomers. This curable functional group-containing fluorinated polymer more preferably contains a polymerization unit based on a fluorine-containing monomer and a polymerization unit based on at least one curable functional group-containing monomer selected from the group consisting of hydroxyl group-containing monomers and carboxyl group-containing monomers.

The polymerization unit based on curable functional group-containing monomer is preferably 8 to 30 mol% with respect to the total polymerization units in the curable functional group-containing fluorinated polymer. A more preferred lower limit is 10 mol% and a more preferred upper limit is 20 mol%.

The curable functional group-containing monomer can be exemplified by the following, but is not limited only to these examples. A single one of these may be used or two or more may be used.

### (1-1) The hydroxyl group-containing monomer:

The hydroxyl group-containing monomer can be exemplified by hydroxyl group-containing vinyl ethers, e.g., 2-hydroxyethyl vinyl ether, 3-hydroxypropyl vinyl ether, 2-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether, and 6-hydroxyhexyl vinyl ether, and by hydroxyl group-containing allyl ethers such as 2-hydroxyethyl allyl ether, 4-hydroxybutyl allyl ether, and glycerol monoallyl ether. The hydroxyl group-containing vinyl ethers are preferred among the preceding for their excellent polymerization reactivity and excellent functional group curability, and at least one monomer selected from the group consisting of 4-hydroxybutyl vinyl ether and 2-hydroxyethyl vinyl ether is particularly preferred.

The hydroxyalkyl esters of (meth)acrylic acid, e.g., 2-hydroxyethyl acrylate and 2-hydroxyethyl methacrylate, are examples of other hydroxyl group-containing monomers.

### (1-2) The carboxyl group-containing monomer:

The carboxyl group-containing monomer can be exemplified by unsaturated carboxylic acids (for example, unsaturated monocarboxylic acids, unsaturated dicarboxylic acids, and so forth) represented by general formula (II) 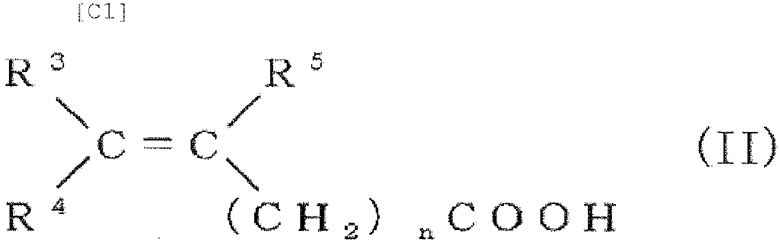 (in the formula, R³, R⁴, and R⁵ are each independently the hydrogen atom, an alkyl group, the carboxyl group, or an ester group, and n is 0 or 1) and their esters and anhydrides, and at least one monomer selected from the group consisting of carboxyl group-containing vinyl ether monomers represented by formula (III)

CH₂=CH(CH₂)ₙO(R⁶OCO)ₘR⁷COOH (III)

(in the formula, R⁶ and R⁷ are each independently a saturated or unsaturated, straight-chain, branched, or cyclic alkyl group, n is 0 or 1, and m is 0 or 1) is preferred.

This carboxyl group-containing monomer can be specifically exemplified by acrylic acid, methacrylic acid, vinylacetic acid, crotonic acid, cinnamic acid, 3-allyloxypropionic acid, 3-(2-allyloxyethoxycarbonyl)propionic acid, itaconic acid, monoesters of itaconic acid, maleic acid, maleate monoesters, maleic anhydride, fumaric acid, fumarate monoesters, vinyl phthalate, and vinyl pyromellitate. Among the preceding, at least one acid selected from the group consisting of crotonic acid, itaconic acid, maleic acid, maleate monoesters, fumaric acid, fumarate monoesters, and 3-allyloxypropionic acid is preferred because this provides a low homopolymerizable and thus inhibits homopolymer formation.

The carboxyl group-containing vinyl ether monomer represented by formula (III) can be specifically exemplified by 3-(2-allyloxyethoxycarbonyl)propionic acid, 3-(2-allyloxybutoxycarbonyl)propionic acid, 3-(2-vinyloxyethoxycarbonyl)propionic acid, 3-(2-vinyloxybutoxycarbonyl)propionic acid, and so forth. Among the preceding, 3-(2-allyloxyethoxycarbonyl)propionic acid is preferred because it offers the advantages of good monomer stability and good polymerization reactivity.

### (1-3) The amino group-containing monomer:

The amino group-containing monomer can be exemplified by amino vinyl ethers represented by CH₂=CH-O-(CH₂)ₓ-NH₂ (x = 0 to 10), allylamines represented by CH₂=CH-O-CO(CH₂)ₓ-NH₂ (x = 1 to 10), and also aminomethylstyrene, vinylamine, acrylamide, vinylacetamide, and vinylformamide.

### (1-4) The silyl group-containing monomer:

The silyl group-containing monomer can be exemplified by silicone-based vinyl monomers. The silicone-based vinyl monomer can be exemplified by (meth)acrylate esters such as CH₂=CHCO₂(CH₂)₃Si(OCH₃)₃, CH₂=CHCO₂(CH₂)₃Si(OC₂H₅)₃, CH₂=C(CH₃)CO₂(CH₂)₃Si(OCR₃)₃, CH₂=C(CH₃)CO₂(CH2)₃Si(OC₂H₅)₃, CH₂=CHCO₂(CH₂)₃SiCH₃(OC₂H₅)₂, CH₂=C(CH₃)CO₂(CH₂)₃SiC₂H₅(OCH₃)₂, CH₂=C(CH₃)CO₂(CH₂)₃Si(CH₃)₂(OC₂H₅), CH₂=C(CH₃)CO₂(CH₂)₃Si(CH₃)₂OH, CH₂=CH(CH₂)₃Si(OCOCH₃)₃, CH₂=C(CH₃)CO₂(CH₂)₃SiC₂H₅(OCOCH₃)₂, CH₂=C(CH₃)CO₂(CH₂)₃SiCH₃(N(CH₃)CONCH₃)₂, CH₂=CHCO₂(CH₂)₃SiCH₃[ON(CH₃)C₂H₅]₂, and CH₂=C(CH₃)CO₂(CH₂)₃SiC₆H₅[ON(CH₃)C₂H₅]₂; vinylsilanes such as CH₂=CHSi[ON=C(CH₃)(C₂H₅)]₃, CH₂=CHSi(OCH₃)₃, CH₂=CHSi(OC₂H₅)₃, CH₂=CHSiCH₃(OCH₃)₂, CH₂=CHSi(OCOCH₃)₃, CH₂=CHSi(CH₃)₂(OC₂H₅), CH₂=CHSi(CH₃)₂SiCH₃(OCH₃)₂, CH₂=CHSiC₂H₅(OCOCH₃)₂, and CH₂=CHSiCH₃[ON(CH₃)C₂H₅]₂, vinyltrichlorosilane, and the partial hydrolyzates of the preceding; and vinyl ethers such as trimethoxysilylethyl vinyl ether, triethoxysilylethyl vinyl ether, trimethoxysilylbutyl vinyl ether, methyldimethoxysilylethyl vinyl ether, trimethoxysilylpropyl vinyl ether, and triethoxysilylpropyl vinyl ether.

The curable functional group-containing fluorinated polymer preferably has a polymerization unit based on a fluorine-containing vinyl monomer.

The polymerization unit based on a fluorine-containing vinyl monomer is preferably 20 to 49 mol% with reference to the total polymerization units in the curable functional group-containing fluorinated polymer. A more preferred lower limit is 30 mol% and an even more preferred lower limit is 40 mol%. A more preferred upper limit is 47 mol%.

The fluorine-containing vinyl monomer is preferably at least one selected from the group consisting of tetrafluoroethylene (TFE), vinylidene fluoride (VdF), chlorotrifluoroethylene (CTFE), vinyl fluoride, hexafluoropropylene, and perfluoro(alkyl vinyl ether). At least one selected from the group consisting of TFE, CTFE, and VdF is more preferred from the standpoint of obtaining an excellent dispersibility, moisture resistance, heat resistance, flame retardancy, adhesiveness, copolymerizability, and chemical resistance. At least one selected from the group consisting of TFE and CTFE is particularly preferred for obtaining an excellent weathering resistance and an even better moisture resistance, while TFE is most preferred.

The curable functional group-containing fluorinated polymer preferably contains at least one polymerization unit based on a fluorine-free vinyl monomer selected from the group consisting of vinyl carboxylate esters, allyl vinyl ethers, and fluorine-free olefins.

The vinyl carboxylate ester functions to improve the compatibility. The vinyl carboxylate ester can be exemplified by vinyl acetate, vinyl propionate, vinyl butyrate, vinyl isobutyrate, vinyl pivalate, vinyl caproate, vinyl versatate, vinyl laurate, vinyl stearate, vinyl cyclohexylcarboxylate, vinyl benzoate, and vinyl para-t-butylbenzoate.

The alkyl vinyl ethers can be exemplified by methyl vinyl ether, ethyl vinyl ether, butyl vinyl ether, and cyclohexyl vinyl ether.

The fluorine-free olefin can be exemplified by ethylene, propylene, n-butene, and isobutene.

Fluorine-free vinyl monomer-based polymerization units preferably constitute all of the polymerization units other than the polymerization units based on curable functional group-containing vinyl monomers and the polymerization units based on fluorine-containing vinyl monomers.

The fluorinated polymer into which a curable functional group has been introduced can be exemplified by the following, categorized according to the polymerization units constituting the polymer.

The fluorinated polymer into which a curable functional group has been introduced can be exemplified by (1) perfluoroolefin-based polymers that mainly contain a perfluoroolefin unit, (2) CTFE-based polymers that mainly contain the chlorotrifluoroethylene (CTFE) unit, (3) VdF-based polymers that mainly contain the vinylidene fluoride (VdF) unit, and (4) fluoroalkyl group-containing polymers that mainly contain a fluoroalkyl unit.

### (1) Perfluoroolefin-based polymers that mainly contain a perfluoroolefin unit

The perfluoroolefin unit in the perfluoroolefin-based polymer is preferably 20 to 49 mol% with reference to the total polymerization units in the perfluoroolefin-based polymer. A more preferred lower limit is 30 mol% and an even more preferred lower limit is 40 mol%. A more preferred upper limit is 47 mol%. Specific examples are tetrafluoroethylene (TFE) homopolymers, copolymers between TFE and, e.g., hexafluoropropylene (HFP), perfluoro(alkyl vinyl ether) (PAVE), and so forth, and copolymers of these monomers with another copolymerizable monomer.

This other copolymerizable monomer can be exemplified by vinyl carboxylate esters such as vinyl acetate, vinyl propionate, vinyl butyrate, vinyl isobutyrate, vinyl pivalate, vinyl caproate, vinyl versatate, vinyl laurate, vinyl stearate, vinyl cyclohexylcarboxylate, vinyl benzoate, and vinyl para-t-butylbenzoate; alkyl vinyl ethers such as methyl vinyl ether, ethyl vinyl ether, butyl vinyl ether, and cyclohexyl vinyl ether; fluorine-free olefins such as ethylene, propylene, n-butene, and isobutene; and fluorine-containing monomers such as vinylidene fluoride (VdF), chlorotrifluoroethylene (CTFE), vinyl fluoride (VF), and fluorovinyl ether, but there is no limitation to only these.

Among the perfluoroolefin-based polymers that mainly contain a perfluoroolefin unit, TFE-based polymers that mainly contain the TFE unit are preferred for their excellent pigment dispersibility, excellent weathering resistance, excellent copolymerizability, and excellent chemical resistance. The TFE unit in the TFE-based polymer is preferably 20 to 49 mol% with reference to the total polymerization units in the TFE-based polymer. A more preferred lower limit is 30 mol% and an even more preferred lower limit is 40 mol%. A more preferred upper limit is 47 mol%.

Curable functional group-containing fluorinated polymers provided by the introduction of a curable functional group into a perfluoroolefin-based polymer that mainly contains a perfluoroolefin unit, can be specifically exemplified by copolymers of TFE/isobutylene/hydroxybutyl vinyl ether/other monomer, copolymers of TFE/vinyl versatate/hydroxybutyl vinyl ether/other monomer, and copolymers of TFE/VdF/hydroxybutyl vinyl ether/other monomer, while at least one copolymer selected from the group consisting of copolymers of TFE/isobutylene/hydroxybutyl vinyl ether/other monomer and copolymers of TFE/vinyl versatate/hydroxybutyl vinyl ether/other monomer is preferred in particular. Coating materials of these curable polymers can be exemplified by the Zeffle (registered trademark) GK series from Daikin Industries, Ltd.

### (2) CTFE-based polymers that mainly contain the chlorotrifluoroethylene (CTFE) unit

Copolymers of CTFE/hydroxybutyl vinyl ether/other monomer can be exemplified by curable functional group-containing fluorinated polymers provided by the introduction of a curable functional group into a CTFE-based polymer that mainly contains the CTFE unit. Examples of curable polymer coating materials of CTFE-based polymers are Lumiflon (registered trademark) from Asahi Glass Co., Ltd., Fluonate (registered trademark) from the DIC Corporation, Cefral Coat (registered trademark) from Central Glass Co., Ltd., and Zaflon (registered trademark) from Toagosei Co., Ltd.

### (3) VdF-based polymers that mainly contain the vinylidene fluoride (VdF) unit

VdF/TFE/hydroxybutyl vinyl ether/other monomer copolymers can be exemplified by curable functional group-containing fluorinated polymers provided by the introduction of a curable functional group into a VdF-based polymer that mainly contains the VdF unit.

### (4) Fluoroalkyl group-containing polymers that mainly contain a fluoroalkyl unit

CF₃CF₂(CF₂CF₂)ₙCH₂CH₂OCOCH=CH₂ (n = mixture of 3 and 4) /2-hydroxyethyl methacrylate/stearyl acrylate copolymers can be exemplified by curable functional group-containing fluorinated polymers provided by the introduction of a curable functional group into a fluoroalkyl group-containing polymer that mainly contains a fluoroalkyl unit. The fluoroalkyl group-containing polymer can be exemplified by Unidyne (registered trademark) and Ftone (registered trademark), both from Daikin Industries, Ltd., and Zonyl (registered trademark) from Du Pont Co., Ltd..

Among the preceding (1) to (4), the fluorinated polymer into which a curable functional group has been introduced is preferably a perfluoroolefin-based polymer from the standpoint of the weathering resistance and moistureproofness while TFE-based polymers that mainly contain the TFE unit are more preferred.

The curable functional group-containing fluorinated polymer can be prepared, for example, by the method disclosed in JP-A 2004-204205.

The coating material for forming the cured coating film also contains an acrylic polymer.

Polymerization units based on acrylic group-containing monomer are preferably at least 5 weight% in the acrylic polymer with reference to the total polymerization units, while at least 10 weight% is more preferred and at least 20 weight% is even more preferred. In addition, considered from the standpoint of obtaining an excellent adherence, weathering resistance, and chemical resistance, they are preferably not more than 98 weight%, more preferably not more than 96 weight%, even more preferably not more than 90 weight%, and particularly preferably not more than 80 weight%.

Viewed in terms of improving the blocking resistance and obtaining a good compatibility with the curable functional group-containing fluorinated polymer, the acrylic polymer in the coating material for obtaining the cured coating film is preferably 1 to 60 mass% with reference to the total amount of the acrylic polymer and curable functional group-containing fluorinated polymer. 1 to 55 mass% is more preferred, 1 to 50 mass% is even more preferred, and 1 to 40 mass% is particularly preferred.

The acrylic polymer is preferably, for example, a polymer that contains a polymerization unit based on an allyl (meth)acrylate. The number of carbons in the alkyl group in this alkyl (meth)acrylate is, for example, 1 to 10.

Here, "alkyl (meth) acrylate" encompasses alkyl acrylates and alkyl methacrylates.

The content of the alkyl (meth)acrylate-based polymerization units is preferably at least 5 weight% in the acrylic polymer because this provides an excellent blocking resistance for the backsheet and an excellent solvent solubility, weathering resistance, water resistance, chemical resistance, and compatibility with the curable functional group-containing fluorinated polymer. At least 10 weight% is more preferred and at least 20 weight% is even more preferred. Viewed from the standpoint of obtaining an excellent adherence, weathering resistance, and chemical resistance, not more than 98 weight% is preferred, not more than 96 weight% is more preferred, not more than 90 weight% is even more preferred, and not more than 80 weight% is particularly preferred.

The acrylic polymer is at least one polymer selected from the group consisting of (i) polymers that contain an alkyl (meth)acrylate-based polymerization unit and that do not have a curable functional group in side chain position and/or main chain terminal position (also referred to below as acrylic polymer (i)) and (ii) copolymers that contain an alkyl (meth)acrylate-based polymerization unit and that have a curable functional group in side chain position and/or main chain terminal position (also referred to below as acrylic polymer (ii)). Acrylic polymer (i) is preferred from the standpoint of the solvent resistance, while acrylic polymer (ii) is preferred from the standpoint of obtaining a better blocking resistance.

The acrylic polymer (i) is preferably a polymer that contains a polymerization unit based on at least one monomer selected from the group consisting of methyl (meth)acrylate, ethyl (meth)acrylate, n-butyl (meth)acrylate, isobutyl (meth)acrylate, 2-ethylhexyl (meth)acrylate, and cyclohexyl (meth)acrylate. The acrylic polymer (i) may be a polymer composed only of such monomer or may be a copolymer composed of such monomer and a polymerization unit based on a copolymerizable ethylenically unsaturated monomer.

Because an excellent solvent solubility, weathering resistance, adherence, and compatibility with the curable functional group-containing fluorinated polymer are thereby provided, the acrylic polymer (i) is preferably a polymer containing a polymerization unit based on at least one monomer selected from the group consisting of isobutyl (meth)acrylate, 2-ethylhexyl (meth)acrylate, and cyclohexyl (meth)acrylate, and is more preferably a copolymer composed of such monomer and a polymerization unit based on a copolymerizable ethylenically unsaturated monomer.

Ethylenically unsaturated monomer that is copolymerizable with the at least one monomer selected from the group consisting of isobutyl (meth)acrylate, 2-ethylhexyl (meth)acrylate, and cyclohexyl (meth)acrylate can be exemplified by aromatic group-containing (meth)acrylates; (meth) acrylates that have a fluorine atom or chlorine atom in the α-position; fluoroalkyl (meth)acrylates in which the fluorine atom is substituted on the alkyl group; vinyl ethers; vinyl esters; aromatic vinyl monomers such as styrene; olefins such as ethylene, propylene, isobutylene, vinyl chloride, and vinylidene chloride; fumarate diesters; maleate diesters; and (meth)acrylonitrile.

Commercially available acrylic copolymers for acrylic polymer (i) can be exemplified by Hitaloid (registered trademark) 1005, Hitaloid 1206, Hitaloid 2330-60, Hitaloid 4001, and Hitaloid 1628A (product names, all from Hitachi Chemical Co., Ltd.); Dianal (registered trademark) LR-1065 and Dianal LR-90 (product names, both from Mitsubishi Rayon Co., Ltd.); Paraloid (registered trademark) B-44, Paraloid A-21, and Paraloid B-82 (product names, all from the Rohm & Haas Company) ; ELVACITE 2000 (product name, Du Pont) ; and Almatex (registered trademark) L1044P (product name, Mitsui Chemicals, Inc.).

The acrylic polymer (ii) has a curable functional group in side chain position and/or main chain terminal position. This curable functional group can be exemplified by the hydroxyl group, carboxyl group, epoxy group, cyano group, amino group, glycidyl group, silyl group, and silanate group, among which at least one group selected from the group consisting of the hydroxyl group, carboxyl group, amino group, cyano group, glycidyl group, and silyl group is more preferred. At least one group selected from the group consisting of the hydroxyl group, amino group, and glycidyl group is even more preferred, and the hydroxyl group is particularly preferred for obtaining an excellent curing reactivity.

The acrylic polymer (ii) is a copolymer that contains an alkyl (meth)acrylate-based polymerization unit, and the number of carbons in the alkyl group in this alkyl (meth)acrylate is preferably 1 to 10.

The acrylic polymer (ii) contains an alkyl (meth)acrylate-based polymerization unit and a polymerization unit based on a monomer that is copolymerizable with this alkyl (meth)acrylate wherein this copolymerizable monomer contains a curable functional group.

The content of the polymerization unit based on a curable functional group-containing monomer that is copolymerizable with alkyl (meth)acrylate is not more than 50 weight% and preferably not more than 40 weight% due to the excellent water resistance, solvent solubility, chemical resistance, weathering resistance, compatibility with the curable functional group-containing fluorinated polymer, and adherence thereby conferred. At least 2 weight% is preferred and at least 4 weight% is more preferred because the water resistance, chemical resistance, adherence, and weathering resistance are then excellent.

The alkyl (meth) acrylate for the acrylic polymer (ii) is preferably at least one monomer selected from the group consisting of methyl (meth)acrylate, ethyl (meth)acrylate, n-butyl (meth)acrylate, isobutyl (meth)acrylate, 2-ethylhexyl (meth)acrylate, and cyclohexyl (meth)acrylate.

The curable functional group-containing monomer that is copolymerizable with alkyl (meth)acrylate is preferably, for example, at least one monomer selected from the group consisting of hydroxyethyl. (meth)acrylate, 2-hydroxypropyl (meth)acrylate, 2-hydroxyethyl vinyl ether, (meth)acrylic acid, glycidyl (meth)acrylate, 2-aminoethyl (meth)acrylate, and 2-aminopropyl (meth)acrylate.

The acrylic polymer (ii) may also be a copolymer that contains an alkyl (meth) acrylate-based polymerization unit, a polymerization unit based on a curable functional group-containing monomer that is copolymerizable with alkyl (meth)acrylate, and a polymerization unit based on an ethylenically unsaturated monomer that is copolymerizable with such monomers.

This ethylenically unsaturated monomer for the acrylic polymer (ii) is preferably an aromatic group-containing (meth)acrylate; a (meth)acrylate that has a fluorine atom or chlorine atom in the α-position; a fluoroalkyl (meth)acrylate in which the fluorine atom is substituted on the alkyl group; a vinyl ether; a vinyl ester; an aromatic vinyl monomer such as styrene; an olefin such as ethylene, propylene, isobutylene, vinyl chloride, and vinylidene chloride; a fumarate diester; a maleate diester; or (meth) acrylonitrile because this provides an excellent solvent solubility, chemical resistance, and adherence.

Commercially available products for the acrylic polymer (ii) are, for example, Hitaloid 3004, Hitaloid 3018, Hitaloid 3046C, Hitaloid 6500B, and Hitaloid 6500 (product names, all from Hitachi Chemical Co., Ltd.); Acrydic (registered trademark) A810-45, Acrydic A814, and Acrydic 47-540 (product names, all from Dainippon Ink and Chemicals, Incorporated); Dianal LR-620, Dianal SS-1084, and Dianal SS-792 (product names, all from Mitsubishi Rayon Co., Ltd.); Olester (registered trademark) Q166, Olester Q185, Olester Q612, and Olester Q723 (product names, all from Mitsui Chemicals, Inc.); and Hariacron 8360 G-55, Hariacron 8360 HS-130, and Hariacron 8160 (product names, all from Harima Chemicals, Inc.).

The number-average molecular weight of the acrylic polymer is preferably 1000 to 200000. 2000 to 100000 is more preferred. The compatibility tends to decline when the number-average molecular weight is too large, while problems with the weathering resistance tend to appear when it is too small.

The total content of the curable functional group-containing fluorinated polymer and the acrylic polymer in the coating material is preferably 20 to 95 mass% where the total amount of nonvolatile components in the coating material is 100 mass%.

The coating material can be prepared by the usual methods, formulated as, for example, a solvent-based coating material, water-based coating material, powder coating material, and so forth. Among these, solvent-based coating material formulations are preferred from the standpoints of the ease of film formation, curability, and excellence in drying.

The solvent in the solvent-based coating material is preferably an organic solvent and can be exemplified by esters such as ethyl acetate, butyl acetate, isopropyl acetate, isobutyl acetate, cellosolve acetate, and propylene glycol methyl ether acetate; ketones such as acetone, methyl ethyl ketone, methyl isobutyl ketone, and cyclohexanone; cyclic ethers such as tetrahydrofuran and dioxane; amides such as N,N-dimethylformamide and N,N-dimethylacetamide; aromatic hydrocarbons such as xylene, toluene, and solvent naphtha; glycol ethers such as propylene glycol methyl ether, and ethyl cellosolve; diethylene glycol esters such as carbitol acetate; aliphatic hydrocarbons such as n-pentane, n-hexane, n-heptane, n-octane, n-nonane, n-decane, n-undecane, n-dodecane, and mineral spirits; and mixed solvents of the preceding.

The esters are more preferred among the preceding, and butyl acetate is even more preferred.

When the coating material is formulated as a solvent-based coating material, the total content of the curable functional group-containing fluorinated polymer and the acrylic polymer is preferably 5 to 95 weight% and more preferably 10 to 70 weight% where the total amount of the coating material is 100 mass%.

Various additives may additionally be incorporated in the coating material in conformity with the properties required thereof. These additives can be exemplified by curing accelerators, curing retarders, pigments, pigment dispersants, defoamants, leveling agents, ultraviolet absorbers, light stabilizers, thickeners, adhesion promoters, matting agents, and so forth.

The curing agent is selected in conformity with the functional group in the curable polymer, and preferred examples for the hydroxyl group-containing fluorinated polymer are isocyanate curing agents, melamine resins, silicate compounds, and isocyanate group-containing silane compounds. In addition, amino curing agents and epoxy curing agents are generally adopted for the carboxyl group-containing fluorinated polymer, while carbonyl group-containing curing agents, epoxy curing agents, and acid anhydride curing agents are typically adopted for the amino group-containing fluorinated polymer.

The curing agent is added to provide preferably 0.1 to 5 mol-equivalents and more preferably 0.5 to 1.5 mol-equivalents per 1 equivalent of the curable functional group in the curable functional group-containing fluorinated polymer and acrylic polymer.

The content of the curable functional group in the curable functional group-containing fluorinated polymer and acrylic polymer can be determined using a suitable combination, depending on the kind of monomer, of NMR, FT-IR, elemental analysis, x-ray fluorescence analysis, and titrimetry.

The curing accelerator can be exemplified by organotin compounds, acidic phosphate esters, reaction products from an acidic phosphate ester and amine, saturated and unsaturated polybasic carboxylic acids and their anhydrides, organotitanate compounds, amine compounds, and lead octylate.

A single curing accelerator may be used or two or more may be used in combination. The curing accelerator is incorporated, expressed per 100 weight parts of the curable functional group-containing fluorinated polymer, preferably at approximately 1.0 × 10⁻¹⁵ to 1.0 × 10⁻² weight parts and more preferably at approximately 5. 0 × 10⁻⁵ to 1.0 × 10⁻³ weight parts.

The coating material preferably also contains a pigment. This serves to endow the resulting cured coating film with an excellent UV-blocking performance. The addition of a pigment is also highly desirable from the standpoint of providing the solar cell module with an aesthetically pleasing appearance.

The pigment can be specifically exemplified by inorganic pigments, e. g., titanium oxide and calcium carbonate, which are white pigments, and carbon black and composite metals such as Cu-Cr-Mn alloys, which are black pigments, and by organic pigments such as phthalocyanine systems, quinacridone systems, and azo systems; however, there is no limitation to only these.

The amount of pigment addition, expressed per 100 weight parts of the curable functional group-containing fluorinated polymer and acrylic polymer, is preferably 0.1 to 200 weight parts and is more preferably 0.1 to 1.60 weight parts.

The coating material preferably additionally contains an ultraviolet absorber. Because solar cells are used on a long-term basis outdoors under strong ultraviolet exposure, countermeasures are required to the ultraviolet-induced degradation of the backsheet. The addition of an ultraviolet absorber to the coating material can impart an ultraviolet-absorbing capacity to the cured coating film layer.

An organic or inorganic ultraviolet absorber can be used as the ultraviolet absorber. The organic compounds can be exemplified by salicylate esters, benzotriazoles, benzophenones, and cyanoacrylates, while filler-type inorganic ultraviolet absorbers such as zinc oxide, cerium oxide, and so forth are preferred for the inorganic compounds.

A single ultraviolet absorber may be used by itself or a combination of two or more may be used. The amount of the ultraviolet absorber is preferably 0.1 to 15 mass% where 100 mass% is the total amount of the curable functional group-containing fluorinated polymer in the coating material. A satisfactory improvement in the light resistance is not obtained when the amount of the ultraviolet absorber is too small, while the effect is saturated when the amount of the ultraviolet absorber is too large.

The cured coating film is provided by the cure of a coating film formed by the application of the aforementioned coating material. The film thickness of the cured coating film is preferably at least 5 µm from the standpoint of obtaining an excellent hiding power, weathering resistance, chemical resistance, and moisture resistance. At least 7 µm is more preferred, at least 10 µm is even more preferred, and at least 20 µm is particularly preferred. Because weight reduction is not achieved when the cured coating film is overly thick, the upper limit is preferably about 1000 µm and more preferably 100 µm. A film thickness of 10 to 40 µm is particularly preferred.

The cured coating film obtained from the aforementioned coating material not only has an excellent adherence for the EVA generally used as a sealant in solar cell modules, but, because it also exhibits an excellent blocking resistance when wound, can be particularly favorably used for coating a solar cell module backsheet that is typically produced using a winding step.

This coating film may be formed on one side or both sides of the substrate, e.g., a water-impermeable sheet, when it is used for coating a solar cell module backsheet.

In instances where a coating film obtained from the coating material of the present invention is formed on one surface of a substrate and the other surface of the substrate remains an uncoated surface, the coating film will then be placed in contact with the uncoated surface of the substrate during a winding step. In instances, on the other hand, where this coating film is formed on one surface of the substrate and a coating film from another coating material (as described below, a cured coating film from a curable functional group-free fluorinated polymer coating material, a coating film from a polyester coating material, a primer layer, and so forth) or another sheet is disposed on the other side of the substrate, the coating film obtained from the coating material of the present invention will then be placed in contact during a winding step with the other sheet or with the other coating material-derived coating film on the substrate. In addition, in instances where the coating film obtained from the coating material of the present invention is formed on both surfaces of a substrate, this coating film will then be placed in contact during a winding step with the same kind of coating film formed on the other surface of the substrate.

In all of these instances, the coating film obtained from the coating material of the present invention can exhibit an excellent blocking resistance with respect to the surface in contact with it.

The substrate sheet is typically a sheet formed from a material that is substantially impermeable to water and is disposed to prevent the permeation of moisture into the EVA sealant and solar cell. Viewed in terms of weight, cost, and flexibility, a sheet formed from a polyester or a metal sheet is preferred. A sheet formed from polyethylene terephtalate (PET) is more preferred. The thickness of the substrate sheet is not particularly limited, but is typically about 50 to 250 µm. An Si-deposited PET sheet is frequently used when moistureproofness is a particular requirement. This thickness is generally about 10 to 20 µm.

The sheet formed from a polyester is preferably a sheet formed from at least one selected from the group consisting of polyethylene terephthalate (PET), polybutylene terephthalate (PBT), and polyether nitrile (PEN). A sheet formed from PET is more preferred. For example, Si-deposited PET sheet and PET sheet are frequently used in solar cell backsheets.

A thin sheet formed from a metal such as aluminum or stainless steel is frequently used as the metal sheet.

The solar cell backsheet of the present invention has a substrate sheet and a cured coating film from a coating material that contains a curable functional group-containing fluorinated polymer and an acrylic polymer. This cured coating film is preferably present at the surface from the standpoint of the blocking resistance.

The solar cell backsheet of the present invention may have a two-layer structure of the substrate sheet and the cured coating film or may have a structure of three or four or more layers that contains the substrate sheet, the cured coating film, and another layer or layers.

The backsheet having a three-layer structure may be, for example, (1) a backsheet having a structure in which the cured coating film from the coating material containing the curable functional group-containing fluorinated polymer and acrylic polymer is present on both sides of the substrate sheet or (2) a backsheet having a structure that has the cured coating film from the coating material containing the curable functional group-containing fluorinated polymer and acrylic polymer on one side of the substrate sheet and another cured coating film or a sheet on the other side (these configurations are shown in Figs. 4 and 5). This other cured coating film or sheet can be exemplified by a coating film from a coating material that contains a fluorinated polymer other than a curable functional group-containing fluorinated polymer, a coating film from a polyester coating material, a fluorinated polymer sheet, and a polyester sheet.

The cured coating film from a fluorinated polymer other than a curable functional group-containing fluorinated polymer can be exemplified by a cured coating film from a coating material provided by the incorporation of a tetraalkoxysilane or partial hydrolyzate thereof into PVdF, as described in JP-A 2004-214342; a cured coating film from a mixed coating material of VdF/TFE/CTFE copolymer and an alkoxysilane unit-containing acrylic resin; a cured coating film from a mixed coating material of VdF/TFE/HFP copolymer and a hydroxyl group-containing acrylic resin; and a cured coating film from a coating material provided by the incorporation of an aminosilane coupling agent into a VdF/HFP copolymer. A film thickness here generally of 5 to 300 µm is preferred from the standpoint of obtaining an excellent hiding power, weathering resistance, chemical resistance, and moisture resistance, while 10 to 100 µm is more preferred and 10 to 50 µm is particularly preferred. An interposed primer layer and so forth may also be present in these cases.

The fluorinated polymer sheet can be, for example, a fluorinated polymer sheet as used in existing backsheets, e.g., a PVdF sheet, PVF sheet, PCTFE sheet, TFE/HFP/ethylene copolymer sheet, TFE/HFP copolymer (FEP) sheet, TFE/PAVE copolymer (PFA) sheet, ethylene/TFE copolymer (ETFE) sheet, or ethylene/CTFE copolymer (CTFE) sheet. The film thickness here is generally 5 to 300 µm while 10 to 100 µm is preferred from the standpoint of obtaining an excellent weathering resistance and 10 to 50 µm is even more preferred.

A polyester sheet as used in conventional backsheets can be used without modification as the polyester sheet referenced above, and its adhesion to the substrate sheet can be carried out with, for example, an acrylic adhesive, a urethane adhesive, an epoxy adhesive, or a polyester adhesive. The film thickness is generally 5 to 300 µm while 10 to 100 µm is preferred from the standpoint of obtaining an excellent weathering resistance, an excellent cost, and an excellent transparency and 10 to 50 µm is even more preferred.

The polyester coating material can be exemplified by polyester coating materials that use a saturated polyester resin that uses, e.g., a polybasic carboxylic acid and a polyhydric alcohol, and by polyester coating materials that use an unsaturated polyester resin that uses a glycol, e.g., maleic anhydride, fumaric acid, and so forth. The coating film can be formed by a coating method such as roll coating, curtain coating, spray coating, and die coating. The film thickness is generally 5 to 300 µm while 10 to 100 µm is preferred from the standpoint of obtaining an excellent hiding power, weathering resistance, chemical resistance, and moisture resistance and 10 to 50 µm is even more preferred. An interposed primer layer and so forth may also be present in this case.

There are no limitations on the method of producing the backsheet of the present invention, but it may be obtained, for example, using the following production method.

The backsheet of the present invention is thus preferably obtained by a production method that includes a step of coating a substrate sheet, or a primer layer formed on a substrate sheet, with the coating material containing the curable functional group-containing fluorinated polymer and the acrylic polymer; a step of curing the thusly applied coating material to form a cured coating film; and a step of winding, into a roll configuration, the sheet constituted of the substrate sheet and the cured coating film from the coating material containing the curable functional group-containing fluorinated polymer and the acrylic polymer.

The present invention is also the wound solar cell module backsheet provided by winding the sheet comprising the cured coating film from the coating material containing the curable functional group-containing fluorinated polymer and the acrylic polymer.

A heretofore known surface treatment may be carried out on the surface of the substrate sheet in order to improve the adhesiveness between the substrate sheet and the cured coating film. This surface treatment can be exemplified by corona discharge treatments, plasma discharge treatments, chemical conversion treatments, and, in the case of a metal sheet, blast treatments.

When the cured coating film is to be formed on a primer layer, the aforementioned production method may then include a step of forming a primer layer on the substrate sheet.

The primer layer may be formed using ordinary methods and a heretofore known primer coating material. Epoxy resins, urethane resins, acrylic resins, silicone resins, and polyester resins are typical examples of primer coating materials.

With regard to the coating temperature, coating may be performed using the usual temperatures conditions in conformity with the coating regime.

In the case of a solvent-based coating material, curing and drying are performed at 10°C to 300°C and generally 100°C to 200°C for 30 seconds to 3 days. Accordingly, materials for which a high-temperature process is desirably avoided, such as Si-deposited PET sheet, can be unproblematically used as the substrate sheet.

Curing and drying may be followed by an aftercure, and this aftercure is typically completed at 20°C to 300°C in 1 minute to 3 days.

After the cured coating layer has been formed, the backsheet of the present invention may be wound into a roll form and then stored. Common winding methods, e.g., the use of a roll, may be adopted for the winding method.

The solar cell module of the present invention is described in the following.

The solar cell module of the present invention is provided with the hereinabove-described solar cell backsheet and with a sealant layer that seals a solar cell in its interior.

There are no particular limitations on the solar cell, and common solar cells can be used.

The sealant layer seals the solar cell in its interior, and an ethylene/vinyl acetate alcohol copolymer (EVA) is typically used.

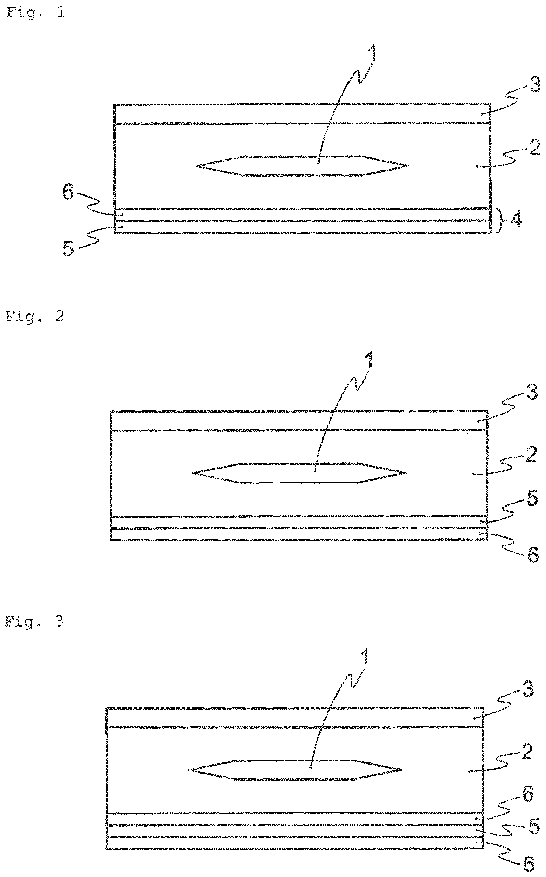

Fig. 1 is a cross-sectional schematic diagram that shows a first embodiment of the solar cell module of the present invention. In Fig. 1, 1 is a solar cell, which is sealed in a sealant layer 2 and sandwiched by a surface layer 3 and a weathering-resistant backsheet 4. The weathering-resistant backsheet 4 is further constituted of a substrate sheet 5 and a cured coating film 6 from a coating material that contains a curable functional group-containing fluorinated polymer and an acrylic polymer. The cured coating film 6 is disposed in this first embodiment on the side of the sealant (EVA) layer 2.

The interfacial adherence with the EVA is improved by co-crosslinking because the cured coating film 6 is in contact with the EVA in this embodiment.

The coating film may be subjected to a heretofore known surface treatment in order to improve the adhesiveness between the coating film and the sealant layer still further. This surface treatment can be exemplified by corona discharge treatments, plasma discharge treatments, chemical conversion treatments, and blast treatments.

Fig. 2 is a cross-sectional schematic diagram that shows a second embodiment of the solar cell module of the present invention. In Fig. 2, the cured coating film 6 is disposed on the opposite side from the sealant (EVA) layer 2. An excellent weathering resistance is brought about in this case due to the disposition of the cured coating film 6. In addition, the sealant (EVA) layer 2 side of the substrate sheet 5 is preferably subjected to a surface treatment in advance from the standpoint of improving the adherence. As necessary, for example, a polyester adhesive, acrylic adhesive, urethane adhesive, or epoxye adhesive may be used.

The solar cell module of the present invention may be provided with a backsheet that has a two-layer structure in which the cured coating film 6 is formed on only one side of the substrate sheet 5 (Figs. 1 and 2), or may be provided with a backsheet that has a three-layer structure as described above (Figs. 3, 4, and 5).

An embodiment of a solar cell module provided with a backsheet having a three-layer structure (third embodiment) is shown in Fig. 3. This third embodiment has a backsheet that has a three-layer structure in which the cured coating film 6 - which is formed of the crosslinked product from the coating material that contains a curable functional group-containing fluorinated polymer and acrylic polymer - is formed on both sides of the substrate sheet 5.

This third embodiment combines the advantages of the first embodiment and second embodiment, although it does represent some retreat with regard to the film thickness of the backsheet.

The solar cell module provided with a backsheet having a three-layer structure can be exemplified by a solar cell module having a backsheet with a structure that has, on one side of the substrate sheet, the cured coating film formed of the crosslinked product from the coating material that contains a curable functional group-containing fluorinated polymer and acrylic polymer, and that has a different cured coating film or a sheet on the other side of the substrate sheet (Figs. 4 and 5).

A fourth embodiment (Fig. 4) has a structure in which a different cured coating film (or a sheet) 7 is formed on the side opposite from the sealant (EVA) layer 2 in the first embodiment, while a fifth embodiment (Fig. 5) has a structure in which another cured coating film (or a sheet) 7 is formed on the sealant (EVA) layer 2 side in the second embodiment.

In both the fourth and fifth embodiments, the material constituting the cured coating film (or sheet) 7 may be a cured coating film from a curable functional group-free fluorinated polymer coating material, a fluorinated polymer sheet, a polyester sheet, or a coating film from a polyester coating material.

The solar cell panel of the present invention is described in the following.

The solar cell panel of the present invention is provided with the hereinabove-described solar cell module. The solar cell panel may have a structure in which the solar cell modules are arrayed in a matrix shape in the length direction and transverse direction or in a radial matrix shape, but other known configurations may be assumed and no particular limitation applies here.

### EXAMPLES

The present invention is described below using examples, but the present invention is not limited only to these examples.

The numerical values provided in the examples were measured using the following methods.

### (Test of the blocking resistance)

This was carried out based on JIS K 5600-3-5. The prepared coating material was applied on 50 mm × 100 mm PET film and was dried by heating in a drier (SPHH-400 from the ESPEC Corp.) at 120°C for 2 minutes. The test specimen was thereafter withdrawn and allowed to cool to room temperature. Films were then sandwiched by glass so the coated side of the test specimen and an uncoated side overlapped with each other over an area of 50 mm × 50 mm. A 20 kg weight was mounted thereon to apply a pressure of 0.08 MPa to the contact surface between the films, followed by holding in this state at 40°C for 24 hours.

For the evaluation, the two films were allowed to cool to room temperature and were then pulled in the opposite directions. The backsheet A1-versus-PET peelability and degree of disturbance in the coating film were visually evaluated from the status at this point and were evaluated on a 5-level scale.

The evaluation scale is as follows.
5: Separation occurs spontaneously.
4: The two sheets are separated using a very slight force.
3: Separation occurs when force is applied and the surface of the coating film is slightly disturbed.
2: Separation occurs when force is applied and the surface of the coating film is disturbed.
1: Separation cannot be brought about even with the application of force.

### (The film thickness)

This was measured using a micrometer (Mitutoyo Corporation) based on JIS C 2151.

### Example 1

A curable coating material was prepared by blending 263 mass parts titanium oxide as a white pigment (D918, Sakai Chemical Industry Co., Ltd.), 167 mass parts butyl acetate, 33 mass parts of a crosslinkable acrylic polymer solution (solids fraction: 50 mass%, Olester (registered trademark) Q612, Mitsui Chemicals, Inc.), and 64 mass parts of an isocyanate curing agent (N3300, Sumika Bayer Urethane Co., Ltd.) (corresponds to 1.0 equivalent per 1 equivalent of the curable functional group in the curable TFE-based copolymer and the crosslinkable acrylic polymer) into 485 mass parts of a hydroxyl group-containing TFE-based copolymer coating material (solids fraction = 65 mass%, Daikin Industries, Ltd., Zeffle GK570).

A PET film (Lumirror S10, from Toray Industries, Inc., thickness = 250 µm, sheet A) was used as the base sheet; the curable coating material prepared was coated on one side of this sheet A using a coater to provide a dry film thickness of 10 µm; and a backsheet A1 with a two-layer structure was then prepared by curing and drying through heating for 2 minutes at 120°C. The blocking resistance of this sample was investigated. The result is given in Table 1.

This backsheet A1 was then aftercured for 48 hours at 40°C; an EVA resin sheet (Solar EVA, from Mitsui Chemicals Fabro Inc., thickness = 600 µm) was placed on its coating film side and glass (thickness = 3.2 mm) was placed on the EVA resin sheet; and a sample A1 with a three-layer structure (structure shown in Fig. 1) was fabricated by press-bonding at 150°C and a pressure of 100 g/cm².

### Examples 2 to 8 and Comparative Example 1

Curable coating materials were prepared by the same method as in Example 1, with the exception that the kind of crosslinkable acrylic polymer solution, blending proportions for the hydroxyl group-containing TFE-based copolymer coating material and crosslinkable acrylic polymer solution, and amount of curing agent incorporation were changed as shown in Table 1 below. This was followed by backsheet fabrication by the same method as in Example 1 and measurement of the blocking resistance. The results are given in Table 1. A glass/EVA/backsheet bonded sample was also fabricated.

**[Table 1]**

| | Example 1 | Example 2 | Example 3 | Example 4 | Example 5 | Example 6 | Example 7 | Example 8 | Comparative Example 1 |
|---|---|---|---|---|---|---|---|---|---|
| Hydroxyl group-containing TFE-based copolymer coating material | GK570 | GK570 | GK570 | GK570 | GK570 | GK570 | GK570 | GK570 | GK570 |
| Kind of acrylic polymer solution | Q612 | Q612 | Q612 | Q612 | Q723 | Q723 | 0723 | Q723 | - |
| Polymer solids fraction in hydroxyl group-containing TFE-based copolymer coating material /solids fraction in acrylic polymer solution (mass ratio) | 95/5 | 90/10 | 80/20 | 70/30 | 95/5 | 90/10 | 80/20 | 70/30 | - |
| Kind of pigment | D918 | D918 | D918 | D918 | D918 | D918 | D918 | D918 | D918 |
| Kind of curing agent | N3300 | N3300 | N3300 | N3300 | N3300 | N3300 | N3300 | N3300 | N3300 |
| Proportion of curing agent in the whole coating material (mass%) | 6.8 (1.0 equivalent) | 6.5 (1.0 equivalent) | 6.0 (1.0 equivalent) | 5.5 (1.0 equivalent) | 6.8 (1.0 equivalent) | 6.5 (1.0 equivalent) | 6.0 (1.0 equivalent) | 6.0 (1.0 equivalent) | 7.1 (1.0 equivalent) |
| Blocking resistance | 4∼5 | 5 | 5 | 5 | 3∼4 | 3∼4 | 5 | 5 | 3 |

### Example 9

A curable coating material was prepared by blending 263 mass parts titanium oxide as a white pigment (D918, Sakai Chemical Industry Co., Ltd.), 167 mass parts butyl acetate, 37 mass parts of a non-crosslinkable acrylic polymer solution (Almatex (registered trademark) L1044P, Mitsui Chemicals, Inc.), and 62 mass parts of an isocyanate curing agent (N3300, Sumika Bayer Urethane Co., Ltd.) (corresponds to 1.0 equivalent per 1 equivalent of the curable functional group in the curable TFE-based copolymer) into 485 mass parts of a hydroxyl group-containing TFE-based copolymer coating material (solids fraction = 65 mass%, Daikin Industries, Ltd., Zeffle GK570).

A backsheet was fabricated by the same method as in Example 1, with the exception that the curable coating material obtained by the preparation method indicated above was used, and the blocking resistance was measured. The results are given in Table 2.

A glass/EVA/backsheet bonded sample was also fabricated.

### Examples 10 to 12 and Comparative Example 2

Curable coating materials were prepared by the same method as in Example 9, with the exception that the blending proportions for the hydroxyl group-containing TFE-based copolymer coating material and non-crosslinkable acrylic polymer solution and the amount of curing agent incorporation were changed as shown in Table 2 below. This was followed by backsheet fabrication by the same method as in Example 9 and measurement of the blocking resistance. The results are given in Table 2. A glass/EVA/backsheet bonded sample was also fabricated.

**[Table 2]**

| | Example 9 | Example 10 | Example 11 | Example 12 | Comparative Example 2 |
|---|---|---|---|---|---|
| Hydroxyl group-containing TFE-based copolymer coating material | GK570 | GK570 | GK570 | GK570 | GK570 |
| Acrylic polymer solution | L1044P | L1044P | L1044P | L1044P | - |
| Polymer solids fraction in hydroxyl group-containing TFE-type copolymer coating material /solids fraction in acrylic polymer solution (mass ratio) | 95/5 | 90/10 | 80/20 | 70/30 | - |
| Kind of pigment | D918 | D918 | D918 | D918 | D918 |
| Kinde of curing agent | N3300 | N3300 | N3300 | N3300 | N3300 |
| Proportion of curing agent in the whole coating material (mass%) | 6.5 (1.0 equivalent) | 6.1 (1.0 equivalent) | 5.3 (1.0 equivalent) | 4.6 (1.0 equivalent) | 7.1 (1.0 equivalent) |
| Blocking resistance | 5 | 5 | 5 | 5 | 3 |

The abbreviations used in Tables 1 and 2 expand as follows.
GK570: Zeffle GK570, a hydroxyl group-containing TFE-based copolymer coating material from Daikin Industries, Ltd.
Q612: Olester Q612, a crosslinkable acrylic polymer solution from Mitsui Chemicals, Inc.
Q723: Olester Q723, a crosslinkable acrylic polymer solution from Mitsui Chemicals, Inc.
D918: D918, a white pigment from Sakai Chemical Industry Co., Ltd.
N3300: N3300, an isocyanate curing agent from Sumika Bayer Urethane Co:, Ltd.
L1044P: Almatex L1044P, a non-crosslinkable acrylic polymer solution from Mitsui Chemicals, Inc.

### (REFERENCE SIGNS LIST)

- 1: solar cell
- 2: sealant layer
- 3: surface layer
- 4: weathering-resistant backsheet
- 5: substrate sheet
- 6: cured coating film
- 7: sheet or coating film
- 8, 9: resin sheet
- 10: backsheet
- 15: first side
- 16: second side
- 17: sheet or coating film

## Claims

1. A backsheet for a solar cell module, comprising a substrate sheet and a cured coating film formed from a coating material that contains a curable functional group-containing fluorinated polymer and an acrylic polymer,
Wherein the acrylic polymer is at least one polymer selected from the group consisting of (i) polymers that contain an alkyl (meth)acrylate-based polymerization unit and that do not have a curable functional group in side chain position and/or main chain terminal position (acrylic polymer (i)) and (ii) co-polymers that contain an alkyl (meth)acrylate-based polymeriza-ton unit and that have a curable functional group in side chain position and/or main chain terminal position (acrylic polymer (ii)),
wherein the acrylic polymer (ii) contains an alkyl (meth)acrylale-based polymerization unit and a polymerisation unit based on a monomer that is copolymerizable with the alkyl (meth)acrylate, wherein the copolymerizable monomer contains a curable functional group, and the content of the polymerization unit based on a curable functional group-containing monomer that is copolymerizable with alkyl (meth)acrylate is not more than 50 weight% in the acrylic polymer with reference to the total polymerization units.

2. The backsheet for a solar cell module according to claim 1,
wherein the curable functional group in the curable functional group-containing fluorinated polymer is at least one group selected from the group consisting or the hydroxyl group (but excluding the hydroxyl group present in the carboxyl group), the carboxyl group, the amino group, the cyano group, and the silyl group.

3. The backsheet for a solar cell module according to claim 1 or 2,
wherein the acrylic polymer in the coating material is 1 to 60 mass% with reference to the total amount of the curable functional group-containing fluorinated polymer and the acrylic polymer.

4. The backsheet for a solar cell module according to claim 1, 2, or 3,
wherein the substrate sheet is a sheet formed from a polyester.

5. A solar cell module, comprising the backsheet according to claim 1, 2, 3, or 4 and a sealant layer that seals a solar cell in its interior.

6. A solar cell panel, comprising the backsheet according to claim 1, 2, 3, or 4.

## Patentansprüche

1. Rückseitiger Bogen für ein Solarzellenmodul, umfassend einen Substratbogen und einen gehärteten Beschichtungsfilm, der aus einem Beschichtungsmaterial gebildet ist, das eine härtbare funktionelle Gruppe enthaltendes fluoriertes Polymer und ein Acrylpolymer enthält,
wobei das Acrylpolymer wenigstens ein Polymer ist, das ausgewählt ist aus der Gruppe bestehend aus (i) Polymeren, die eine Polymerisationseinheit auf Alkyl(meth)acrylatbasis enthalten und die keine härtbare funktionelle Gruppe in einer Seitenkettenposition und/oder Hauptkettenendposition aufweisen (Acrylpolymer (i)) und (ii) Copolymeren, die eine Polymerisationseinheit auf Alkyl(meth)acrylatbasis enthalten und die eine härtbare funktionelle Gruppe in einer Seitenkettenposition und/oder Hauptkettenendposition aufweisen (Acrylpolymer (ii)),
wobei das Acrylpolymer (ii) eine Polymerisationseinheit auf Alkyl(meth)acrylatbasis und eine Polymerisationseinheit auf Basis eines Monomers, das mit dem Alky(meth)acrylat copolymerisierbar ist, enthält, wobei das copolymerisierbare Monomer eine härtbare funktionelle Gruppe enthält, und wobei der Gehalt der Polymerisationseinheit basierend auf einem eine härtbare funktionelle Gruppe enthaltenden Monomer, das mit Alkyl(meth)acrylat copolymerisierbar ist, nicht mehr als 50 Gew.-% in dem Acrylpolymer in Bezug auf die gesamten Polymerisationseinheiten ist.

2. Rückseitiger Bogen für ein Solarzellenmodul nach Anspruch 1,
wobei die härtbare funktionelle Gruppe in dem eine härtbare funktionelle Gruppe enthaltenden fluorierten Polymer wenigstens eine Gruppe ist, die ausgewählt ist aus der Gruppe bestehend aus der Hydroxylgruppe (jedoch ausschließend die Hydroxylgruppe, die in der Carboxylgruppe vorhanden ist), der Carboxylgruppe, der Aminogruppe, der Cyanogruppe und der Silylgruppe.

3. Rückseitiger Bogen für ein Solarzellenmodul nach Anspruch 1 oder 2,
wobei das Acrylpolymer in dem Beschichtungsmaterial 1 bis 60 Massenprozent in Bezug auf die gesamte Menge des eine härtbare funktionelle Gruppe enthaltenden fluorierten Polymers und des Acrylpolymers ist.

4. Rückseitiger Bogen für ein Solarzellenmodul nach Anspruch 1, 2 oder 3,
wobei der Substratbogen ein Bogen ist, der aus einem Polyester gebildet ist.

5. Solarzellenmodul, umfassend den rückseitigen Bogen nach Anspruch 1, 2, 3 oder 4 und eine Versiegelungsschicht, die eine Solarzelle in ihrem Inneren versiegelt.

6. Solarzellenplatte, umfassend den rückseitigen Bogen nach Anspruch 1, 2, 3 oder 4.

## Revendications

1. Plaque solaire pour module de cellules solaires comprenant une feuille de substrat et un film de revêtement durci formé à partir d'un matériau de revêtement qui contient un polymère fluoré contenant un groupe fonctionnel durcissable et un polymère acrylique,
dans lequel le polymère acrylique est au moins un polymère sélectionné dans le groupe constitué (i) de polymères qui contiennent une unité de polymérisation à base de (méth)acrylate d'alkyle et qui ne possèdent pas de groupe fonctionnel durcissable à la position de la chaîne latérale et/ou à la position terminale de la chaîne principale (polymère acrylique (i)) et de copolymères (ii) qui contiennent une unité de polymérisation à base de (méth)acrylate d'alkyle et qui possèdent un groupe fonctionnel durcissable à la position de la chaîne latérale et/ou à la position de la chaîne principale (polymère acrylique (ii)),
dans lequel le polymère acrylique (ii) contient une unité de polymérisation à base de (méth)acrylate d'alkyle et une unité de polymérisation à base de monomère qui est polymérisable avec le (méth)acrylate d'alkyle, dans lequel le monomère copolymérisable contient un groupe fonctionnel durcissable, et la teneur de l'unité de polymérisation à base de monomère contenant un groupe fonctionnel durcissable qui est copolymérisable avec le (méth)acrylate d'alkyle n'est pas supérieure à 50 % en poids dans le polymère acrylique par rapport au nombre total des unités de polymérisation.

2. Plaque arrière pour module de cellules solaires selon la revendication 1,
dans lequel le groupe fonctionnel durcissable dans le polymère fluoré contenant un groupe fonctionnel durcissable est au moins un groupe sélectionné dans le groupe constitué du groupe hydroxyle (mais à l'exclusion du groupe hydroxyle présent dans le groupe carboxyle), du groupe carboxyle, du groupe amino, du groupe cyano et du groupe silyle.

3. Plaque arrière pour module de cellules solaires selon la revendication 1 ou 2,
dans lequel le polymère acrylique dans le matériau de revêtement représente 1 à 60 % en masse par rapport à la quantité totale du polymère fluoré contenant le groupe fonctionnel durcissable et le polymère acrylique.

4. Feuille arrière pour module de cellules solaires selon la revendication 1, 2 ou 3.
dans laquelle la plaque arrière est une plaque formée à partir d'un polyester.

5. Module de cellules solaires, comprenant la plaque arrière selon la revendication 1, 2, 3 ou 4 et une couche d'étanchéité qui scelle une cellule solaire dans son intérieur.

6. Panneau de cellules solaires, comprenant la plaque arrière selon la revendication 1, 2, 3 ou 4.
